# EUROPEAN PATENT APPLICATION

(11) **EP 4 810 503 A1**
(43) Date of publication of application: **23.09.2026**
(21) Application number: 25864511.8
(22) Date of filing: 05.09.2025
(51) Int. Cl.: C07F 9/09, C07F 9/24, C08G 79/04, G02B 1/04, G02B 5/02, H10K 50/85, G09F 9/30

(54) **LOW-REFRACTIVE-INDEX COMPOUND, PREPARATION METHOD THEREFOR, AND LOW-REFRACTIVE-INDEX OPTICAL FILM AND DISPLAY DEVICE, WHICH COMPRISE SAME**

(30) Priority: 26.11.2024 KR 20240170590
(71) Applicant: Hansol Chemical Co., Ltd., Gangnam-gu Seoul 06169 (KR)
(72) Inventor: KIM, Cheol Eui, Wanju-gun, Jeonbuk-do 55321 (KR); KIM, Yo Seph, Wanju-gun, Jeonbuk-do 55321 (KR); LIM, So Yeun, Wanju-gun, Jeonbuk-do 55321 (KR); YOON, Ran, Wanju-gun, Jeonbuk-do 55321 (KR); KIM, Hyun Seok, Wanju-gun, Jeonbuk-do 55321 (KR); HA, Sung Min, Wanju-gun, Jeonbuk-do 55321 (KR)
(74) Representative: Cabinet Beau de Loménie
(86) International application number: PCT/KR2025/013762
(87) International publication number: WO 2026/116699

(57) **Abstract**

Disclosed herein are a low refractive index compound, a method of preparing the same, and a low refractive index optical film and a display apparatus comprising the same. Having both a low refractive index properties and high viscosity, the low refractive index compound according to the present invention is highly suitable for manufacture of low refractive index layers or optical films with low reflectance and for use in mold patterning. Accordingly, the present invention enables economical production of a low refractive index optical film with uniform quality and can provide a high-quality display apparatus with improved luminous efficacy using the low refractive index optical film.

## Description

### [Technical Field]

The present invention relates to a low refractive index compound, a method of preparing the same, and a low refractive index optical film and a display apparatus including the same.

### [Background Art]

UV-assisted resin patterning plays a critical role in enhancing product performance by enabling formation of micro-patterns in various fields, including displays, optics, and biosensors. Driven by recent technological advancements, application of UV-assisted resin patterning has continued to expand into new industrial sectors.

In particular, mold patterning is a technique of creating microstructures using a mold and is widely utilized to enhance luminous efficacy and product quality in various fields, including displays and luminaires. Mold patterning is suitable for manufacture of high-resolution displays due to the ability to precisely form nanometer-scale microstructures, facilitates realization of any desired patterns using a mold, and enables high-speed mass production of films while ensuring quality uniformity.

Accordingly, research is ongoing to develop light extraction films capable of maximizing light extraction efficiency through control of light scattering and refraction, using mold patterning. Such light extraction films include a low refractive index compound to reduce total internal reflection of incident light. Despite having a low refractive index suitable for light extraction films, currently commercially available fluorine-based low refractive index compounds exhibit low viscosity properties (about 1 cP to 10 cP), causing problems, such as failure to retain a mold pattern or insufficient mechanical strength, when used in mold patterning.

Therefore, there is a need for a novel low refractive index compound that can achieve high viscosity properties required for reliable mold patterning while exhibiting low refractive index properties suitable for light extraction films and the like.

### [Disclosure]

### [Technical Problem]

It is one aspect of the present invention to provide a novel low refractive index compound that exhibits both low refractive index properties and high viscosity properties, and a method of preparing the same.

It is another aspect of the present invention to provide a low refractive index optical film and a display apparatus including the low refractive index compound as set forth above.

However, the technical problems to be solved by the present invention are not limited to those mentioned above and other technical problems not mentioned will be apparent to those skilled in the art from the detailed description of the invention.

### [Technical Solution]

In accordance with one aspect of the present invention, there is provided a low refractive index compound represented by Formula 1:

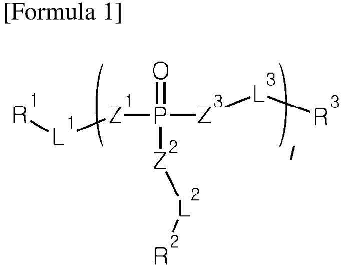

in Formula 1,
Z¹ to Z³ are each independently -NH- or -O-,
L¹ to L³ are each independently a C₁ to C₁₂ hydrocarbon group, provided that a hydrogen atom contained in the hydrocarbon group is substitutable with fluorine, a C₁ to C₁₀ alkyl group, or a C₁ to C₁₀ alkanol group,
R¹ to R³ are each independently a reactive group or a fluorine (F)-containing group, provided that there is no case in which all of R¹ to R³ are reactive groups or all of R¹ to R³ are fluorine-containing groups,
1 is an integer of 1 to 100, provided that, when 1 is an integer of 2 to 100, a plurality of 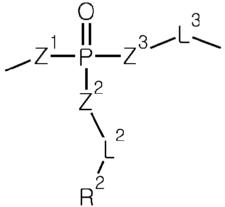 are identical to each other or different from each other,
the reactive group is an acryl group or a methacryl group, and
the fluorine-containing group is -(CF₂)ₓ-CHF₂ or -(CF₂)_{y}-CH₂OH,
(x and y being each independently an integer of 1 to 10).

The compound represented by Formula 1 may be a compound represented by Formula 2: 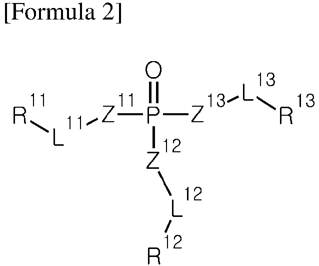 in Formula 2,
Z¹¹ to Z¹³ are each independently -NH- or -O-,
L¹¹ to L¹³ are each independently a C₁ to C₁₂ hydrocarbon group, provided that a hydrogen atom contained in the hydrocarbon group is substitutable with fluorine, a C₁ to C₁₀ alkyl group, or a C₁ to C₁₀ alkanol group,
R¹¹ to R¹³ are each independently a reactive group or a fluorine (F)-containing group, provided that there is no case in which all of R¹¹ to R¹³ are reactive groups or all of R¹¹ to R¹³ are fluorine-containing groups,
the reactive group is an acryl group or a methacryl group, and
the fluorine-containing group is -(CF₂)ₓ-CHF₂ or -(CF₂)_{y}-CH₂OH
(x and y being each independently an integer of 1 to 10).

The compound represented by Formula 1 may be a copolymer represented by Formula 3:

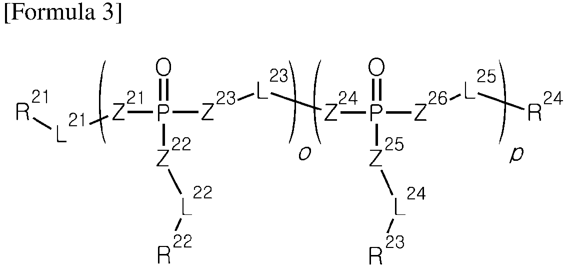

in Formula 3,
Z²¹ to Z²⁶ are each independently -NH- or -O-,
L²¹ to L²⁵ are each independently a C₁ to C₁₂ hydrocarbon group, provided that a hydrogen atom contained in the hydrocarbon group is substitutable with fluorine, a C₁ to C₁₀ alkyl group, or a C₁ to C₁₀ alkanol group,
R²¹ to R²⁴ are each independently a reactive group or a fluorine-containing group, provided that there is no case in which all of R²¹ to R²⁴ are reactive groups or all of R²¹ to R²⁴ are fluorine-containing groups,
o and p are each independently an integer of 1 to 20,
the reactive group is an acryl group or a methacryl group, and
the fluorine-containing group is -(CF₂)ₓ-CHF₂ or -(CF₂)_{y}-CH₂OH
(x and y being each independently an integer of 1 to 10).

The compound represented by Formula 1 may be a copolymer represented by Formula 4: 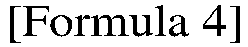 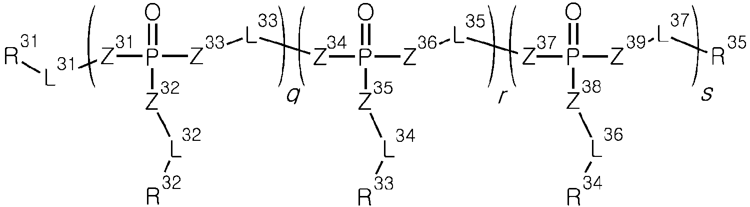 in Formula 4,
Z³¹ to Z³⁹ are each independently -NH- or -O-,
L³¹ to L³⁷ are each independently a C₁ to C₁₂ hydrocarbon group, provided that a hydrogen atom contained in the hydrocarbon group is substitutable with fluorine, a C₁ to C₁₀ alkyl group, or a C₁ to C₁₀ alkanol group,
R³¹ to R³⁵ are each independently a reactive group or a fluorine-containing group, provided that there is no case in which all of R³¹ to R³⁵ are reactive groups or all of R³¹ to R³⁵ are fluorine-containing groups,
q, r, and s are each independently an integer of 1 to 20,
the reactive group is an acryl group or a methacryl group, and
the fluorine-containing group is -(CF₂)ₓ-CHF₂ or -(CF₂)_{y}-CH₂OH
(x and y being each independently an integer of 1 to 10).

The low refractive index compound may have a refractive index of 1.34 to 1.41.

The low refractive index compound may have a viscosity of 50 cP or more.

In accordance with another aspect of the present invention, there is provided a method of preparing a low refractive index compound, the method including: (a) synthesizing a low refractive index compound using a phosphoryl halide, a compound containing a reactive group, and a compound containing a fluorine-containing group; and (b) purifying the synthesized low refractive index compound, wherein the compound containing a reactive group includes a compound represented by Formula 5 and the compound containing a fluorine-containing group includes HO-(CF₂)ₓ-CHF₂ or HOCH₂-(CF₂)_{y}-CH₂OH (x and y being each independently an integer of 1 to 10). 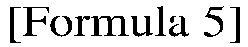 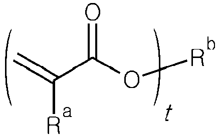 in Formula 5,
R^{a} is a hydrogen atom or a methyl group,
R^{b} is a C₁ to C₁₂ hydrocarbon group having a terminal -OH group, and
t is an integer of 1 to 3.

Step (a) may include synthesizing the low refractive index compound further using a compound represented by Formula 6:

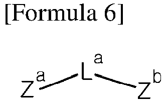

in Formula 6,
Z^{a} and Z^{b} are each independently -NH₂ or -OH, and
L^{a} is a C₁ to C₁₂ hydrocarbon group, provided that a hydrogen atom contained in the hydrocarbon group is substitutable with fluorine, a C₁ to C₁₀ alkyl group, or a C₁ to C₁₀ alkanol group.

The low refractive index compound may be a compound represented by Formula 1.

In accordance with a further aspect of the present invention, there is provided a low refractive index optical film including the low refractive index compound as set forth above.

In accordance with yet another aspect of the present invention, there is provided a display apparatus including the low refractive index optical film as set forth above.

### [Advantageous Effects]

Embodiments of the present invention provide a low refractive index compound that has a phosphine compound as a backbone and contains a reactive group for photocuring and a fluorine (F)-containing group to reduce refractive index, thereby achieving both low refractive index properties and high viscosity properties.

Embodiments of the present invention provide a low refractive index compound that can be effectively used in manufacture of low refractive index layers or low refractive index optical films with low reflectance, due to low refractive index properties thereof, thereby improving luminous efficacy of display apparatuses and the like.

Embodiments of the present invention provide a low refractive index compound that exhibits high viscosity properties while achieving low refractive index properties and is highly suitable for use in mold patterning capable of precise microstructure formation, thereby enabling economical production of high-quality, low refractive index optical films with uniform quality.

Embodiments of the present invention provide a method of preparing a low refractive index compound that achieves both low refractive index properties and high viscosity properties.

### [Best Mode]

Unless stated otherwise, all terms (including technical and scientific terms) as used herein have a meaning generally understood by those skilled in the art. It will be further understood that terms, such as those defined in commonly used dictionaries, should be interpreted as having a meaning that is consistent with their meaning in the context of the specification and relevant art and should not be interpreted in an idealized or overly formal sense unless expressly so defined herein.

It will be further understood that the terms "comprises" and/or "comprising," when used in this specification, specify the presence of stated components and/or steps, but do not preclude the presence or addition of one or more other components and/or steps, unless stated otherwise.

In addition, as used herein, the term "(meth)acrylate" refers to acrylate and methacrylate, the term "(meth)acryl" refers to acryl and methacryl, and the term "(meth)acryloyl" refers to acryloyl and methacryloyl.

### <Low refractive index compound>

A low refractive index compound according to the present invention is a compound represented by Formula 1.

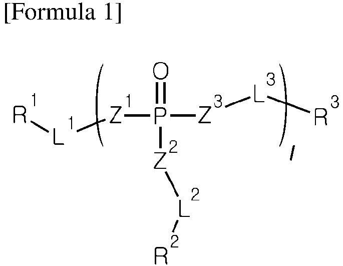

In Formula 1, Z¹ to Z³ may be each independently -NH- or -O-.

In Formula 1, L¹ to L³ may be each independently a C₁ to C₁₂ hydrocarbon group.

The C₁ to C₁₂ hydrocarbon group may be a divalent to tetravalent hydrocarbon group.

Examples of the divalent hydrocarbon group may include: linear alkanediyl groups, such as a methylene group, an ethylene group, a propylene group, a butylene group, a pentylene group, a hexylene group, a heptylene group, an octylene group, a nonylene group, a decylene group, and a dodecylene group; branched alkanediyl groups, such as an isopropylene group, an isobutylene group, an isopentylene group, a neopentylene group, a 2-ethylhexylene group, a sec-butylene group, a 1,3-dimethylbutylene group, and a 2-ethylbutylene group; and cycloaliphatic alkanediyl groups, such as a cyclopropylene group, a cyclopentylene group, a cyclohexylene group, a cycloheptylene group, a cyclooctylene group, and a tricyclodecylene group.

Examples of the trivalent hydrocarbon group may include a methanetriyl group, an ethanetriyl group, a propanetriyl group, a butanetriyl group, a pentanetriyl group, a hexanetriyl group, a heptanetriyl group, an octanetriyl group, a nonanetriyl group, a decanetriyl group, and a dodecanetriyl group.

Examples of the tetravalent hydrocarbon group may include a methanetetrayl group, an ethanetetrayl group, a propanetetrayl group, a butanetetrayl group, a pentanetetrayl group, a hexanetetrayl group, a heptanetetrayl group, an octanetetrayl group, a nonanetetrayl group, a decanetetrayl group, and a dodecanetetrayl group.

In Formula 1, each of R¹ to R³ may be present in a plurality when L¹ to L³ are trivalent or tetravalent hydrocarbon groups. For example, when L¹ to L³ are trivalent hydrocarbon groups, each of R¹ to R³ may appear twice and, when L¹ to L³ are tetravalent hydrocarbon groups, each of R¹ to R³ may appear three times.

A hydrogen atom contained in the hydrocarbon group may be substituted with fluorine, a C₁ to C₁₀ alkyl group, or a C₁ to C₁₀ alkanol group.

Examples of the C₁ to C₁₀ alkyl group may include: linear alkyl groups, such as a methyl group, an ethyl group, a propyl group, a butyl group, a pentyl group, a hexyl group, a heptyl group, an octyl group, a nonyl group, a decyl group, a dodecyl group, a hexadecyl group, and an icosyl group; branched alkyl groups, such as an isopropyl group, an isobutyl group, an isopentyl group, a neopentyl group, a 2-ethylhexyl group, a sec-butyl group, a 1,3-dimethylbutyl group, and a 2-ethylbutyl group; and cycloaliphatic alkyl groups, such as a cyclopropyl group, a cyclopentyl group, a cyclohexyl group, a cycloheptyl group, a cyclooctyl group, and a tricyclodecyl group.

Examples of the C₁ to C₁₀ alkanol group may include a methanol group, an ethanol group, a propanol group, a butanol group, a pentanol group, a hexanol group, a heptanol group, an octanol group, a nonanol group, a decanol group, a dodecanol group, an isopropanol group, an isobutanol group, an isopentanol group, a neopentanol group, a 2-ethylhexanol group, a sec-butanol group, a 1,3-dimethylbutanol group, a 2-ethylbutanol group, a cyclopropanol group, a cyclopentanol group, a cyclohexanol group, a cycloheptanol group, a cyclooctanol group, and a tricyclodecanol group.

In Formula 1, R¹ to R³ may be each independently a reactive group or a fluorine-containing group. However, there is no case in which all of R¹ to R³ are reactive groups, nor is there a case in which all of R¹ to R³ are fluorine-containing groups. That is, at least one of R¹ to R³ is a reactive group and at least one of R¹ to R³ is a fluorine-containing group.

The reactive group is introduced for photocuring and may be an acryl group or a methacryl group.

The fluorine-containing group is introduced to reduce a refractive index of the compound and may be -(CF₂)ₓ-CHF₂ or -(CF₂)_{y}-CH₂OH, where x and y may be each independently an integer of 1 to 10.

In Formula 1, l may be an integer of 1 to 100. However, when l is an integer of 2 to 100, a plurality of 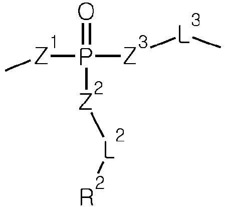 may be identical to each other or different from each other.

Typical fluorine-containing acrylate compounds have been used to reduce an overall refractive index of a composition; however, they result in decreased viscosity due to reduced surface energy. Accordingly, films formed of compositions including such compounds suffer from insufficient hardness and poor scratch resistance.

Conversely, the low refractive index compound represented by Formula 1 is characterized by having a phosphine compound as a backbone and containing at least one reactive group and at least one fluorine-containing group in a molecular structure thereof. Unlike typical fluorine-containing acrylate compounds, the low refractive index compound according to the present invention is considered capable of exhibiting both low refractive index and high viscosity properties despite the presence of the fluorine-containing group in the molecular structure, due to introduction of the phosphine compound as the backbone.

In one embodiment, the compound represented by Formula 1 may further include other structural units without impairing the intended effects of the present invention.

The low refractive index compound may have a refractive index of 1.34 to 1.41, preferably 1.35 to 1.40, more preferably 1.36 to 1.395.

The low refractive index compound may have a viscosity of 50 cP or more, preferably 80 cP or more, more preferably 100 cP or more. Given that the mechanical strength and scratch resistance of an optical film formed using the low refractive index compound can be enhanced as the viscosity of the low refractive index compound increases, an upper limit of the viscosity is not particularly restricted and may be, for example, 500,000 cP or less, or 300,000 cP or less.

The low refractive index compound may have a weight average molecular weight (Mw) of 800 g/mol to 10,000 g/mol, preferably 1,000 g/mol to 5,000 g/mol.

In one embodiment, the compound represented by Formula 1 may be a compound represented by Formula 2.

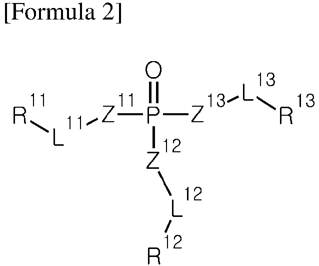

In Formula 2, Z¹¹ to Z¹³ may be each independently -NH- or -O-.

In Formula 2, L¹¹ to L¹³ may be each independently a C₁ to C₁₂ hydrocarbon group, wherein a hydrogen atom contained in the hydrocarbon group may be substituted with fluorine, a C₁ to C₁₀ alkyl group, or a C₁ to C₁₀ alkanol group.

The C₁ to C₁₂ hydrocarbon group, the C₁ to C₁₀ alkyl group, and the C₁ to C₁₀ alkanol group are as described above.

In Formula 2, R¹¹ to R¹³ may be each independently a reactive group or a fluorine-containing group. However, there is no case in which all of R¹¹ to R¹³ are reactive groups, nor is there a case in which all of R¹¹ to R¹³ are fluorine-containing groups. That is, at least one of R¹¹ to R¹³ is a reactive group and at least one of R¹¹ to R¹³ is a fluorine-containing group.

The reactive group and the fluorine-containing group are as described above.

In one embodiment, the compound represented by Formula 1 may be a copolymer represented by Formula 3.

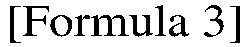

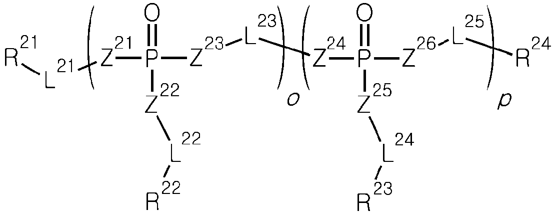

In Formula 3, Z²¹ to Z²⁶ may be each independently -NH- or -O-.

In Formula 3, L²¹ to L²⁵ may be each independently a C₁ to C₁₂ hydrocarbon group, wherein a hydrogen atom contained in the hydrocarbon group may be substituted with fluorine, a C₁ to C₁₀ alkyl group, or a C₁ to C₁₀ alkanol group.

The C₁ to C₁₂ hydrocarbon group, the C₁ to C₁₀ alkyl group, and the C₁ to C₁₀ alkanol group are as described above.

In Formula 3, R²¹ to R²⁴ may be each independently a reactive group or a fluorine-containing group. However, there is no case in which all of R²¹ to R²⁴ are reactive groups, nor is there a case in which all of R²¹ to R²⁴ are fluorine-containing groups. That is, at least one of R²¹ to R²⁴ is a reactive group, and at least one of R²¹ to R²⁴ is a fluorine-containing group.

The reactive group and the fluorine-containing group are as described above.

In Formula 3, o and p may be each independently an integer of 1 to 20.

In one embodiment, the compound represented by Formula 1 may be a copolymer represented by Formula 4.

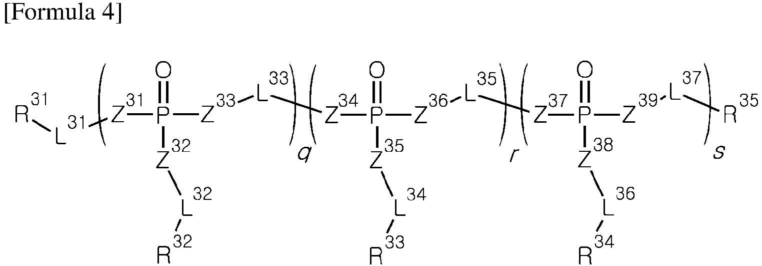

In Formula 4, Z³¹ to Z³⁹ may be each independently -NH- or -O-.

In Formula 4, L³¹ to L³⁷ may be each independently a C₁ to C₁₂ hydrocarbon group, wherein a hydrogen atom contained in the hydrocarbon group may be substituted with fluorine, a C₁ to C₁₀ alkyl group, or a C₁ to C₁₀ alkanol group.

The C₁ to C₁₂ hydrocarbon group, the C₁ to C₁₀ alkyl group, and the C₁ to C₁₀ alkanol group are as described above.

In Formula 4, R³¹ to R³⁵ may be each independently a reactive group or a fluorine-containing group. However, there is no case in which all of R³¹ to R³⁵ are reactive groups, nor is there a case in which all of R³¹ to R³⁵ are fluorine-containing groups. That is, at least one of R³¹ to R³⁵ is a reactive group and at least one of R³¹ to R³⁵ is a fluorine-containing group.

The reactive group and the fluorine-containing group are as described above.

In Formula 4, q, r, and s may be each independently an integer of 1 to 20.

### <Method for preparing a low refractive index compound>

A method of preparing a low refractive index compound according to the present invention includes: (a) synthesizing a low refractive index compound using a phosphoryl halide, a compound containing a reactive group, and a compound containing a fluorine-containing group; and (b) purifying the synthesized low refractive index compound.

In step (a), a low refractive index compound is synthesized from starting materials.

First, diluted solutions are prepared by diluting each of the phosphoryl halide, the compound containing a reactive group, and the compound containing a fluorine-containing group, as the starting materials, in a solvent. Here, given that exothermic reaction occurs to form a salt upon dissolving the starting materials in the solvent, the step of preparing the diluted solutions is preferably performed at low temperature to suppress heat generation. Preparation of the diluted solutions may be performed at a temperature of -20°C to 15°C, preferably -10°C to 10°C, more preferably -5°C to 5°C.

The phosphoryl halide may include at least one selected from the group consisting of phosphoryl trifluoride, phosphoryl trichloride, phosphoryl tribromide, and phosphoryl triiodide, preferably phosphoryl trichloride.

The compound containing a reactive group may include a compound represented by Formula 5.

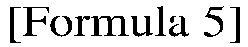

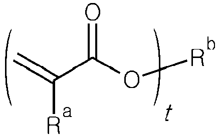

In Formula 5, R^{a} may be a hydrogen atom or a methyl group.

In Formula 5, R^{b} may be a C₁ to C₁₂ hydrocarbon group having a terminal - OH group.

The C₁ to C₁₂ hydrocarbon group may be a divalent to tetravalent hydrocarbon group.

The divalent hydrocarbon group, the trivalent hydrocarbon group, and the tetravalent hydrocarbon group are as described above.

In Formula 5, t is an integer of 1 to 3. However, when t is 2 or 3, a plurality of 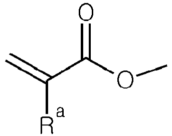 may be identical to each other or different from each other.

The compound containing a fluorine-containing group may be HO-(CF₂)ₓ-CHF₂ or HOCH₂-(CF₂)_{y}-CH₂OH, where x and y may be each independently an integer of 1 to 10.

The solvent may include any solvent that can dissolve the phosphoryl halide, the compound containing a reactive group, and the compound containing a fluorine-containing group, without particular limitation. Examples of the solvent may include: polar aprotic solvents, such as N,N-dimethylformamide, N,N-dimethylacetamide, N-methylpyrrolidone, dimethyl sulfoxide, acetone, methyl ethyl ketone, and methyl isobutyl ketone; polar protic solvents, such as triethylamine, methanol, ethanol, propanol derivatives (PrOH, iso-PrOH), and butanol derivatives (n-BuOH, tert-BuOH); and non-polar solvents, such as benzene, toluene, xylene, mesitylene, tetrahydrofuran, dioxane, and dichloromethane.

In one embodiment, step (a) may be synthesizing the low refractive index compound by further including a compound represented by Formula 6.

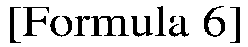

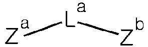

In Formula 6, Z^{a} and Z^{b} may be each independently -NH₂ or -OH.

In Formula 6, L^{a} may be a C₁ to C₁₂ hydrocarbon group, wherein a hydrogen atom contained in the hydrocarbon group may be substituted with fluorine, a C₁ to C₁₀ alkyl group, or a C₁ to C₁₀ alkanol group. For example, -CH₂- contained in the hydrocarbon group may be replaced with -CF₂- in which all hydrogen atoms thereof are substituted with fluorine.

The C₁ to C₁₂ hydrocarbon group, the C₁ to C₁₀ alkyl group, and the C₁ to C₁₀ alkanol group are as described above.

Next, a synthesis reaction is performed by sequentially adding the diluted solution of the compound containing a reactive group and the diluted solution of the compound containing a fluorine-containing group to the diluted solution of the phosphoryl halide. Here, the order of adding the diluted solution of the compound containing a reactive group and the diluted solution of the compound containing a fluorine-containing group may be appropriately changed depending on the desired structure of the compound and the like. It is desirable that the diluted solution of the compound containing a reactive group and the diluted solution of the compound containing a fluorine-containing group be added slowly. If the diluted solutions are added all at once or at a high rate, the yield of synthesis can decrease, leading to an increase in the proportion of by-products.

Addition of the diluted solution of the compound containing a reactive group or the diluted solution of the compound containing a fluorine-containing group may be performed at a temperature of -20°C to 15°C, preferably -10°C to 10°C, more preferably -5°C to 5°C to suppress heat generation.

The synthesis reaction may be performed at a temperature of 10 to 40°C, preferably 15°C to 35°C, more preferably 20°C to 30°C, for a duration of 6 hours to 72 hours, preferably for 12 hours to 48 hours.

In step (b), only the low refractive index compound according to the present invention is purified from materials produced in step (a). Step (b) may include a primary filtration step, a neutralization step, a washing step, a drying step, and a secondary filtration step.

In the primary filtration step, an organic layer containing the low refractive index compound is separated from a reaction mixture after completion of the reaction. For example, the organic layer may be separated by filtering the reaction mixture under reduced pressure.

In the neutralization step, the resulting filtrate containing the organic layer is neutralized. Here, unnecessary side reactions can be prevented by sequentially adding an acidic solution and a basic solution to neutralize the filtrate.

After completion of the neutralization step, it is desirable to perform the washing step to remove by-products remaining in the filtrate. After completion of the washing step, the organic layer formed in the filtrate is dried.

In the secondary filtration step, the dried organic layer is filtered and dried under reduced pressure to obtain a final product. Upon completion of the secondary filtration step, the low refractive index compound in a liquid state is obtained.

### <Low refractive index optical film and display apparatus>

The present invention provides a low refractive index optical film including the low refractive index compound as set forth above. The low refractive index optical film may be manufactured by a process including: coating the low refractive index compound onto a substrate, followed by exposure and development in a predetermined pattern; and curing the patterned layer.

The substrate is not particularly restricted and may include, for example, a substrate having a flat surface, such as a glass substrate, a silicon substrate, a polycarbonate substrate, a polyester substrate, an aromatic polyamide substrate, a polyamide-imide substrate, a polyimide substrate, an Al substrate, and a GaAs substrate. The substrate may be subjected to pretreatment, such as chemical treatment with chemical agents such as silane coupling agent, plasma treatment, ion plating treatment, sputtering treatment, gas-phase reaction treatment, or vacuum deposition treatment. In addition, the substrate may be formed with a barrier matrix.

The low refractive index optical film may be a light extraction film, wherein the light extraction film may be manufactured using mold patterning. Methods of manufacturing a light extraction film using mold patterning are well known in the art and a detailed description thereof will be omitted herein.

Furthermore, the present invention provides a display apparatus including the low refractive index optical film as set forth above. The display apparatus may include a liquid crystal display (LCD), an electroluminescent display (EL), a plasma display panel (PDP), a field emission display (FED), and an organic light-emitting diode (OLED) display, without being limited thereto. The display apparatus according to the present invention may further include a blue light source, besides the low refractive index optical film, and may include other components known in the art, as needed.

### [Mode for Invention]

Next, the present invention will be described in more detail with reference to some examples. It should be understood that these examples are provided for illustration only and are not to be construed in any way as limiting the present invention.

### <EXAMPLE>

### Example 1

60 g (391.3 mmol) of phosphoryl trichloride was diluted in 600 g of toluene, followed by stirring. A solution prepared by diluting 186 g (802.3 mmol) of 2,2,3,3,4,4,5,5-octafluoro-1-pentanol and 87 g (861.1 mmol) of triethylamine in 60 g of toluene was added dropwise to the resulting reaction mixture at 0°C for 1.5 hours, followed by stirring at room temperature for 1 hour. Then, a solution prepared by diluting 116.7 g (391.4 mmol) of pentaerythritol triacrylate and 43.6 g (430.5 mmol) of triethylamine in 60 g of toluene was added dropwise to the resulting reaction mixture at 0°C for 30 minutes, followed by stirring at room temperature for 18 hours. After completion of the reaction, the resulting reaction product was filtered under reduced pressure to remove by-products. The resulting filtrate was diluted in 400 mL of ethyl acetate, neutralized once with 500 mL of a 1N aqueous hydrochloric acid solution, and neutralized once with 500 mL of an aqueous sodium bicarbonate solution, followed by washing the resulting organic layer once with 500 mL of an aqueous sodium chloride solution. Thereafter, the organic layer was dried over magnesium sulfate and filtered, followed by drying the resulting filtrate under reduced pressure, thereby obtaining 130 g of a liquid compound represented by Formula 1-1. The obtained compound had a refractive index of 1.379, as measured with an Abbe refractometer, and a viscosity of 103 cP, as measured with a rheometer.

¹H NMR (400 MHz, CDCl₃) δ 6.44 - 6.38 (m, 3H), 6.19 - 6.04 (m, 5H), 5.93 - 5.84 (m, 3H), 4.59 - 4.51 (m, 6H), 4.30 - 4.14 (m, 6H).

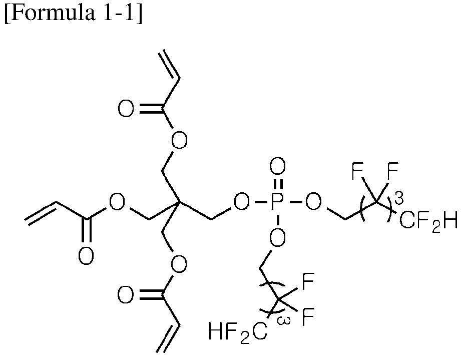

### Example 2

60 g (391.3 mmol) of phosphoryl trichloride was diluted in 600 g of toluene, followed by stirring. A solution prepared by diluting 50 g (430.4 mmol) of 2-hydroxyethyl acrylate and 47.6 g (469.6 mmol) of triethylamine in 60 g of toluene was added dropwise to the resulting reaction mixture at 0°C for 2 hours, followed by stirring at room temperature for 17 hours. Then, a solution prepared by diluting 100 g (430.4 mmol) of 2,2,3,3,4,4,5,5-octafluoro-1-pentanol and 47.6 g (469.6 mmol) of triethylamine in 60 g of toluene was added dropwise to the resulting reaction mixture at 0°C for 2 hours, followed by stirring at room temperature for 6 hours. Thereafter, a solution prepared by diluting 11.8 g (195.7 mmol) of ethylenediamine and 23.8 g (234.8 mmol) of triethylamine in 30 g of toluene was added dropwise to the resulting reaction mixture at 0°C for 30 minutes, followed by stirring at room temperature for 18 hours. After completion of the reaction, the resulting reaction product was neutralized once with 500 mL of a 1N aqueous hydrochloric acid solution and neutralized once with 500 mL of an aqueous sodium bicarbonate solution, followed by washing the resulting organic layer once with 500 mL of an aqueous sodium chloride solution. Thereafter, the organic layer was dried over magnesium sulfate and filtered, followed by drying the resulting filtrate under reduced pressure, thereby obtaining 145 g of a liquid compound represented by Formula 1-2.

¹H NMR (400 MHz, CDCl₃) δ 6.45 - 6.41 (m, 2H), 6.17 - 6.14 (m, 2H), 5.91 - 5.88 (m, 2H), 4.58 - 4.45 (m, 8H), 4.40 - 4.37 (m, 8H), 4.25 - 4.20 (m, 2H).

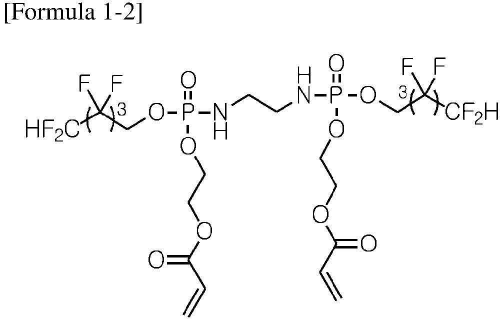

### Example 3

60 g (391.3 mmol) of phosphoryl trichloride was diluted in 600 g of dichloromethane, followed by stirring. A solution prepared by diluting 46.3 g (399.1 mmol) of 2-hydroxyethyl acrylate and 43.6 g (430.4 mmol) of triethylamine in 60 g of dichloromethane was added dropwise to the resulting reaction mixture at 0°C for 1 hour, followed by stirring at room temperature for 3 hours. Then, 84.5 g (182.8 mmol) of 2,2,3,3,4,4,5,5,6,6,7,7,8,8,9,9-hexadecafluoro-1,10-decanediol and 39.6 g (391.3 mmol) of triethylamine were added to the resulting reaction mixture at 0°C, followed by stirring at room temperature for 2 hours. Thereafter, a solution prepared by diluting 27.2 g (117.4 mmol) of 2,2,3,3,4,4,5,5-octafluoro-1-pentanol and 15.8 g (156.5 mmol) of triethylamine in 60 g of dichloromethane was added to the resulting reaction mixture at 0°C, followed by stirring at room temperature for 18 hours. After completion of the reaction, the resulting reaction product was filtered under reduced pressure to remove by-products. The resulting filtrate was diluted in 400 mL of ethyl acetate, neutralized once with 500 mL of a 1N aqueous hydrochloric acid solution, and neutralized once with 500 mL of an aqueous sodium bicarbonate solution, followed by washing the resulting organic layer once with 500 mL of an aqueous sodium chloride solution. Thereafter, the organic layer was dried over magnesium sulfate and filtered, followed by drying the resulting filtrate under reduced pressure, thereby obtaining 135 g of a liquid compound represented by Formula 1-3.

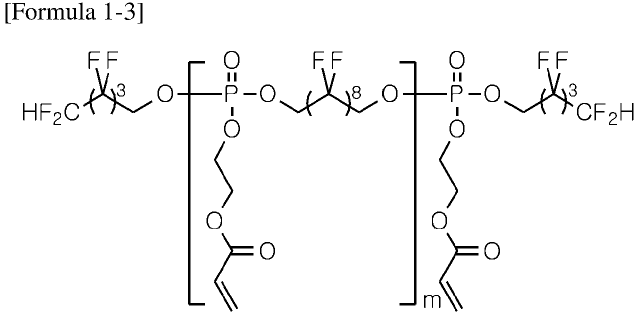

### Example 4

19.8 g (129.2 mmol) of phosphoryl trichloride was diluted in 200 g of dichloromethane, followed by stirring. A solution prepared by diluting 15.4 g (132.6 mmol) of 2-hydroxyethyl acrylate and 14.2 g (140.3 mmol) of triethylamine in 20 g of dichloromethane was added dropwise to the resulting reaction mixture at 0°C for 30 minutes, followed by stirring at room temperature for 2 hours, thereby preparing Reactant A. Separately, 39.6 g (258.3 mmol) of phosphoryl trichloride was diluted in 400 g of dichloromethane, followed by stirring. A solution prepared by diluting 60.8 g (262.0 mmol) of 2,2,3,3,4,4,5,5-octafluoro-1-pentanol and 28.9 g (285.6 mmol) of triethylamine in 40 g of dichloromethane was added dropwise to the resulting reaction mixture at 0°C for 1 hour, followed by stirring at room temperature for 2 hours, thereby preparing Reactant B.

Reactant A and Reactant B were filtered under reduced pressure to remove by-products. Thereafter, a solution prepared by diluting 12.2 g (195.7 mmol) of ethylene glycol and 39.6 g (391.3 mmol) of triethylamine in 60 g of dichloromethane was added to the resulting filtrate at 0°C, followed by stirring at room temperature for 2 hours. Then, a solution prepared by diluting 27.2 g (117.2 mmol) of 2,2,3,3,4,4,5,5-octafluoro-1-pentanol and 15.8 g (156.1 mmol) of triethylamine in 60 g of dichloromethane was added to the resulting reaction mixture at 0°C, followed by stirring at room temperature for 18 hours. After completion of the reaction, the resulting reaction product was filtered under reduced pressure to remove by-products. The resulting filtrate was diluted in 400 mL of ethyl acetate, neutralized once with 500 mL of a 1N aqueous hydrochloric acid solution, and neutralized once with 500 mL of an aqueous sodium bicarbonate solution, followed by washing the resulting organic layer once with 500 mL of an aqueous sodium chloride solution. Thereafter, the organic layer was dried over magnesium sulfate and filtered, followed by drying the resulting filtrate under reduced pressure, thereby obtaining 82.6 g of a liquid compound represented by Formula 1-4 (m:n = 1:2).

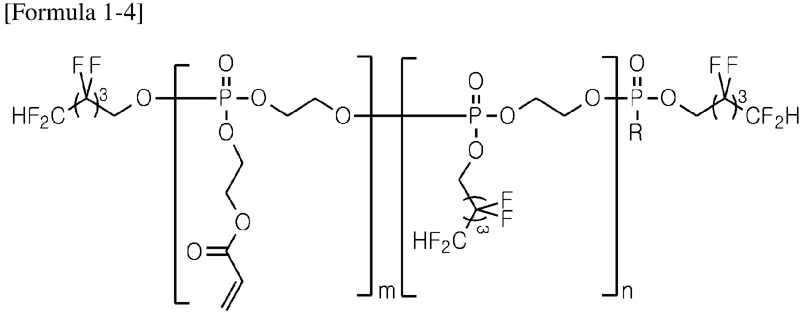

### Example 5

60 g (391.3 mmol) of phosphoryl trichloride was diluted in 700 mL of toluene and then cooled in an ice bath. Then, a solution prepared by diluting 47.5 g (469.56 mmol) of triethylamine and 50 g (430.43 mmol) of 2-hydroxyethyl acrylate in 110 mL of toluene was slowly added dropwise thereto for 1 hour, followed by stirring at room temperature for 15 hours. After completion of the first reaction, the resulting reaction product was cooled in an ice bath and then a solution prepared by diluting 317.8 g (1369.60 mmol) of 2,2,3,3,4,4,5,5-octafluoro-1-pentanol and 145.19 g (1434.82 mmol) of triethylamine in 70 mL of toluene was slowly added dropwise thereto for 1 hour, followed by stirring the reaction mixture at room temperature for 3 hours. After completion of the second reaction, the resulting reaction product was filtered under reduced pressure to remove the resulting amine salt. The resulting filtrate was washed sequentially with a 1M aqueous hydrochloric acid solution, an aqueous sodium bicarbonate solution, and distilled water (once each). Then, the resulting organic layer was dried over magnesium sulfate and filtered, followed by drying the resulting filtrate under reduced pressure, thereby obtaining 240 g of a liquid compound represented by Formula 1-5. The obtained compound had a refractive index of 1.368, as measured with an Abbe refractometer, and a viscosity of 70 cP, as measured with a rheometer.

¹H NMR (400 MHz, CDCl₃) δ 6.50 - 6.43 (m, 1H), 6.17 - 6.09 (m, 1H), 6.20 - 5.86 (m, 2H), 5.94 - 5.87 (m, 1H), 4.52 (m, 4H), 4.43 - 4.34 (m, 4H).

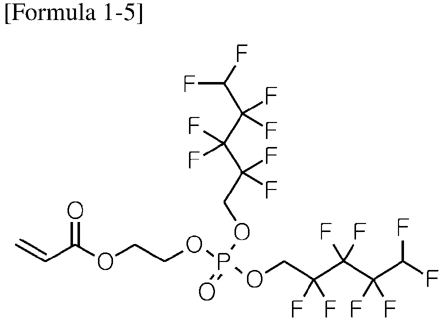

### Example 6

60 g (391.3 mmol) of phosphoryl trichloride was diluted in 700 mL of toluene and then cooled in an ice bath. Then, a solution prepared by diluting 43.5 g (430.4 mmol) of triethylamine and 46.35 g (399.13 mmol) of 2-hydroxyethyl acrylate in 110 mL of toluene was slowly added dropwise thereto for 1 hour, followed by stirring at room temperature for 15 hours. After completion of the first reaction, the resulting reaction product was cooled in an ice bath and then a solution prepared by diluting 92.6 g (399.13 mmol) of 2,2,3,3,4,4,5,5-octafluoro-1-pentanol and 47.5 g (469.56 mmol) of triethylamine in 70 mL of toluene was slowly added dropwise thereto for 1 hour, followed by stirring the reaction mixture at room temperature for 15 hours. Separately, 26.2 g (195.65 mmol) of 2-ethyl-2-(hydroxymethyl)propane-1,3-diol and 43.6 g (430.43 mmol) of triethylamine were dissolved in 70 mL of toluene under heating. Then, the reaction mixture was slowly added dropwise thereto, followed by stirring at room temperature for 30 minutes. After completion of the reaction, the resulting reaction product was filtered under reduced pressure to remove the resulting amine salt and then the resulting filtrate was washed sequentially with a 1M aqueous hydrochloric acid solution, an aqueous sodium bicarbonate solution, and distilled water (once each). Thereafter, the resulting organic layer was dried over magnesium sulfate and filtered, followed by drying the resulting filtrate under reduced pressure, thereby obtaining 240 g of a compound represented by Formula 1-6. The obtained compound had a refractive index of 1.394, as measured with an Abbe refractometer, and a viscosity of 206 cP, as measured with a rheometer.

¹H NMR (400 MHz, DMSO) δ 7.22 - 6.83 (m, 8H), 6.39 - 6.28 (m, 3H), 6.24 - 6.10 (m, 3H), 6.02 - 5.87 (m, 3H), 4.94 - 4.55 (m, 12H), 4.39 - 4.20 (m, 9H), 4.13 - 3.89 (m, 13H), 3.89 - 3.76 (m, 5H), 1.76 - 1.48 (m, 16H), 1.44 - 1.22 (m, 15H)

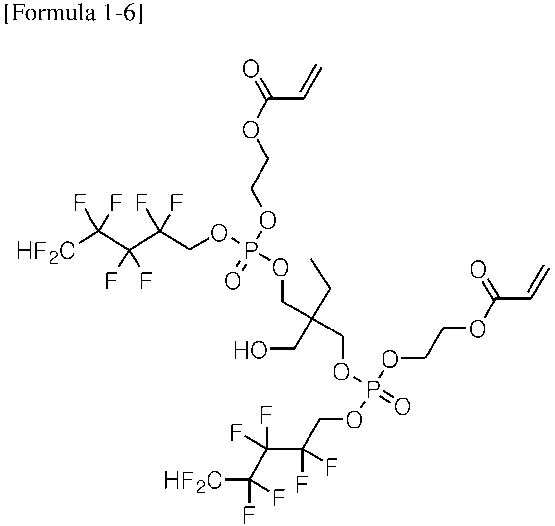

### Example 7

30 g (195.66 mmol) of phosphoryl trichloride was diluted in 300 mL of toluene and then cooled in an ice bath. Then, a solution prepared by diluting 24 g (234.8 mmol) of triethylamine and 25 g (215.2 mmol) of 2-hydroxyethyl acrylate in 50 mL of toluene was slowly added dropwise thereto for 1 hour, followed by stirring at room temperature for 15 hours. After completion of the first reaction, the resulting reaction product was cooled in an ice bath and then a solution prepared by diluting 48.6 g (209.63 mmol) of 2,2,3,3,4,4,5,5-octafluoro-1-pentanol and 23.76 g (234.8 mmol) of triethylamine in 30 mL of toluene was slowly added dropwise thereto for 1 hour, followed by stirring the resulting reaction mixture at room temperature for 3 hours. After completion of the second reaction, a solution prepared by dissolving 45.2 g (97.82 mmol) of 1H,1H,10H,10H-perfluorodecane-1,10-diol and 23.76 g (234.79 mmol) of triethylamine in 30 mL of toluene was slowly added dropwise thereto for 1 hour and then the resulting reaction product was stirred at room temperature for 15 hours and filtered to remove the resulting amine salt. The resulting filtrate was washed sequentially with a 1M aqueous hydrochloric acid solution, an aqueous sodium bicarbonate solution, and distilled water (once each). Subsequently, the resulting organic layer was dried over magnesium sulfate and filtered, followed by concentrating the resulting filtrate under reduced pressure. The resulting compound was diluted in 300 mL of chloroform and stirred using 9 g of activated carbon for 1 hour. Thereafter, the resulting product was filtered through a diatomaceous earth filter and concentrated under reduced pressure, thereby obtaining 90 g of a liquid compound represented by Formula 1-7. The obtained compound had a refractive index of 1.371, as measured with an Abbe refractometer, and a viscosity of 2,452 cP, as measured with a rheometer.

¹H NMR (400 MHz, CDCl₃) δ 6.46 (ddd, J = 17.4, 1.3, 0.7 Hz, 2H), 6.19 - 6.09 (m, 2), 5.93 - 5.88 (m, 2H), 6.19-5.90(m, 2H) 4.61 - 4.45 (m, 8H), 4.45 - 4.27 (m, 9H), 4.09 (m, 1H)

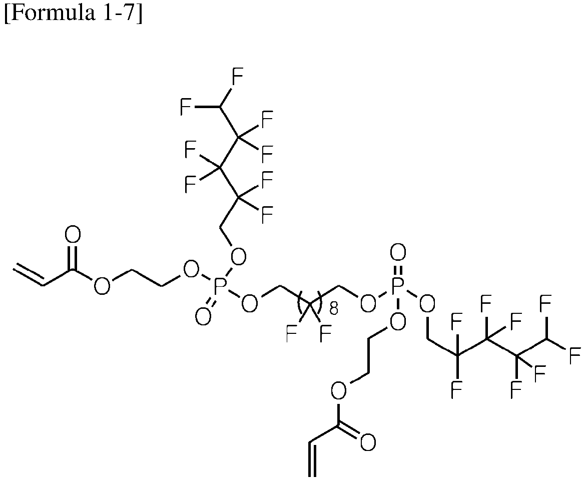

### Example 8

60 g (391.3 mmol) of phosphoryl trichloride was diluted in 450 mL of dichloromethane and then cooled in an ice bath. Then, a solution prepared by diluting 43.55 g (430.43 mmol) of triethylamine and 92.6 g (399.14 mmol) of 2,2,3,3,4,4,5,5-octafluoro-1-pentanol in 45 mL of dichloromethane was slowly added dropwise thereto in the ice bath for 1 hour, followed by stirring at room temperature for 3 hours. After completion of the first reaction, a solution prepared by dissolving 11.76 g (195.65 mmol) of ethylenediamine and 39.60 g (391.3 mmol) of triethylamine in 45 mL of dichloromethane was slowly added dropwise thereto for 30 minutes, followed by stirring the resulting reaction product at 40°C for 2 hours, and then the internal temperature of a corresponding flask was reduced to room temperature. After completion of the second reaction, a solution prepared by diluting 13.6 g (117.39 mmol) of 2-hydroxyethyl acrylate and 15.84 g (156.52 mmol) of triethylamine in 45 mL of dichloromethane was added to the flask. Thereafter, the resulting reaction mixture was stirred at room temperature for 15 hours and then filtered to remove the resulting amine salt. The resulting filtrate was washed sequentially with a 1M aqueous hydrochloric acid solution, an aqueous sodium bicarbonate solution, and distilled water (once each). Thereafter, the resulting organic layer was dried over magnesium sulfate and filtered, followed by concentrating the resulting filtrate under reduced pressure, thereby obtaining 75 g of a liquid compound represented by Formula 1-8. The obtained compound had a refractive index of 1.393, as measured with an Abbe refractometer, and a viscosity of 52,146 cP, as measured with a rheometer.

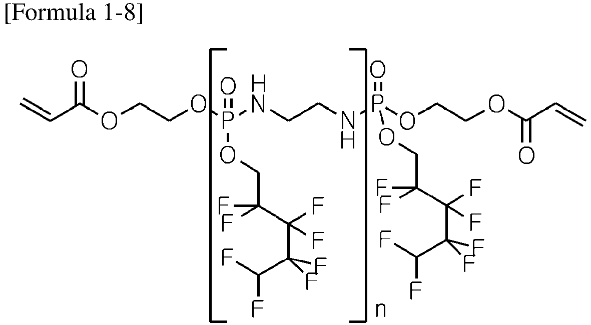

### Example 9

60 g (391.3 mmol) of phosphoryl trichloride was diluted in 450 mL of dichloromethane and then cooled in an ice bath. Then, a solution prepared by diluting 43.55 g (430.43 mmol) of triethylamine and 92.6 g (399.14 mmol) of 2,2,3,3,4,4,5,5-octafluoro-1-pentanol in 45 mL of dichloromethane was slowly added dropwise thereto in the ice bath for 1 hour, followed by stirring at room temperature for 3 hours. After completion of the first reaction, a solution prepared by dissolving 12.14 g (195.65 mmol) of ethylene glycol and 39.60 g (391.3 mmol) of triethylamine in 45 mL of dichloromethane was slowly added dropwise for 30 minutes, followed by stirring the resulting reaction product at 40°C for 2 hours, and then the internal temperature of a corresponding flask was reduced to room temperature. After completion of the second reaction, a solution prepared by diluting 13.6 g (117.39 mmol) of 2-hydroxyethyl acrylate and 15.84 g (156.52 mmol) of triethylamine in 45 mL of dichloromethane was added to the flask. Thereafter, the resulting reaction mixture was stirred at room temperature for 15 hours and then filtered to remove the resulting amine salt. The resulting filtrate was concentrated under reduced pressure, subjected to extraction with ethyl acetate, and washed sequentially with a 1M aqueous hydrochloric acid solution, an aqueous sodium bicarbonate solution, and distilled water (once each). Thereafter, the resulting organic layer was dried over magnesium sulfate and filtered, followed by concentrating the resulting filtrate under reduced pressure, thereby obtaining 92 g of a liquid compound represented by Formula 1-9. The obtained compound had a refractive index of 1.377, as measured with an Abbe refractometer, and a viscosity of 124 cP, as measured with a rheometer.

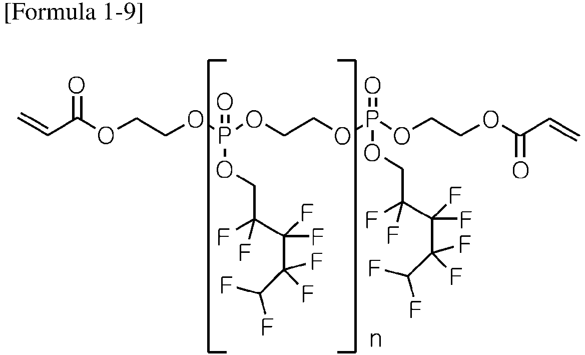

### Example 10

30 g (195.66 mmol) of phosphoryl trichloride was diluted in 230 mL of dichloromethane in a round-bottom flask and then cooled in an ice bath. Then, a solution prepared by diluting 21.8 g (215.23 mmol) of triethylamine and 46.31 g (199.57 mmol) of 2,2,3,3,4,4,5,5-octafluoro-1-pentanol in 20 mL of dichloromethane was slowly added dropwise thereto for 1 hour, followed by stirring at room temperature for 3 hours. 30 g (195.66 mmol) of phosphoryl trichloride was diluted in 230 mL of dichloromethane in another round-bottom flask and then cooled in an ice bath. Then, a solution prepared by diluting 23.17 g (199.57 mmol) of 2-hydroxyethyl acrylate and 21.78 g (215.23 mmol) of triethylamine in 20 mL of dichloromethane was slowly added dropwise thereto for 1 hour, followed by stirring the resulting reaction mixture at room temperature for 3 hours. After completion of the first reactions, the resulting reaction products were filtered to remove the resulting amine salts, followed by collecting the two filtrates in a single four-neck round-bottom flask. A solution prepared by dissolving 11.76 g (195.65 mmol) of ethylenediamine and 43.56 g (430.46 mmol) of triethylamine in 45 mL of dichloromethane was slowly added dropwise to the flask for 30 minutes, followed by stirring the resulting reaction product at 40°C for 2 hours, and then the internal temperature of the flask was reduced to room temperature. After completion of the second reaction, a solution prepared by diluting 15.84 g (156.53 mmol) of triethylamine and 27.24 g (117.4 mmol) of 2,2,3,3,4,4,5,5-octafluoro-1-pentanol in 45 mL of dichloromethane was added to the flask. Thereafter, the resulting reaction mixture was stirred at room temperature for 15 hours and then filtered to remove the resulting amine salt. The resulting filtrate was concentrated under reduced pressure, subjected to extraction with ethyl acetate, and washed sequentially with a 1M aqueous hydrochloric acid solution, an aqueous sodium bicarbonate solution, and distilled water (once each). Thereafter, the resulting organic layer was dried over magnesium sulfate and filtered, followed by concentrating the resulting filtrate under reduced pressure, thereby obtaining 80 g of a liquid compound represented by Formula 1-10. The obtained compound had a refractive index of 1.403, as measured with an Abbe refractometer, and a viscosity of 3,284 cP, as measured with a rheometer.

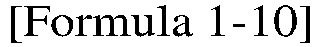

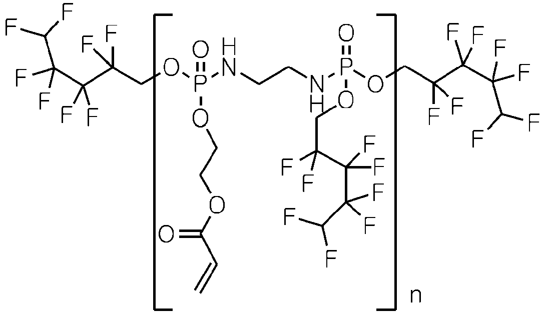

### Example 11

30 g (195.66 mmol) of phosphoryl trichloride was diluted in 230 mL of dichloromethane in a round-bottom flask and then cooled in an ice bath. Then, a solution prepared by diluting 21.8 g (215.23 mmol) of triethylamine and 46.31 g (199.57 mmol) of 2,2,3,3,4,4,5,5-octafluoro-1-pentanol in 20 mL of dichloromethane was slowly added dropwise thereto for 1 hour, followed by stirring at room temperature for 3 hours. 30 g (195.66 mmol) of phosphoryl trichloride was diluted in 230 mL of dichloromethane in another round-bottom flask and then cooled in an ice bath. Then, a solution prepared by diluting 23.17 g (199.57 mmol) of 2-hydroxyethyl acrylate and 21.78 g (215.23 mmol) of triethylamine in 20 mL of dichloromethane was slowly added dropwise thereto for 1 hour, followed by stirring the reaction mixture at room temperature for 3 hours. After completion of the first reactions, the resulting reaction products were filtered to remove the resulting amine salts, followed by collecting the two resulting filtrates into a single four-neck round-bottom flask. A solution prepared by dissolving 12.14 g (195.65 mmol) of ethylene glycol and 43.56 g (430.46 mmol) of triethylamine in 45 mL of dichloromethane was slowly added dropwise to the flask for 30 minutes, followed by stirring the reaction product at 40°C for 2 hours, and then the internal temperature of the flask was reduced to room temperature. After completion of the second reaction, a solution prepared by diluting 15.84 g (156.53 mmol) of triethylamine and 27.24 g (117.4 mmol) of 2,2,3,3,4,4,5,5-octafluoro-1-pentanol in 45 mL of dichloromethane was added to the flask. Thereafter, the resulting reaction mixture was stirred at room temperature for 15 hours and then filtered to remove the resulting amine salt. The resulting filtrate was concentrated under reduced pressure, subjected to extraction with ethyl acetate, and washed sequentially with a 1M aqueous hydrochloric acid solution, an aqueous sodium bicarbonate solution, and distilled water (once each). Thereafter, the resulting organic layer was dried over magnesium sulfate and filtered, followed by concentrating the resulting filtrate under reduced pressure, thereby obtaining 72 g of a liquid compound represented by Formula 1-11 (m:n = 1:1). The obtained compound had a refractive index of 1.369, as measured with an Abbe refractometer, and a viscosity of 153 cP, as measured with a rheometer.

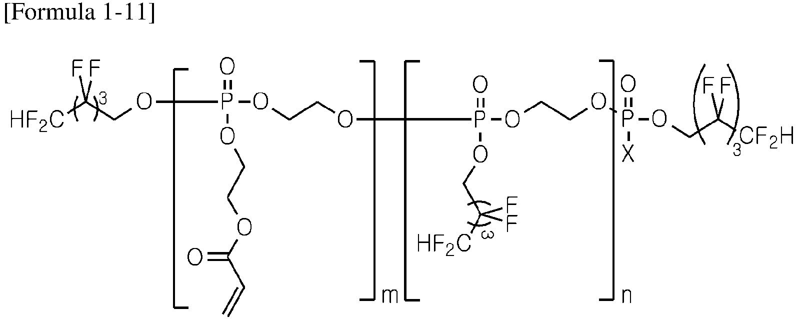

### Example 12

30 g (195.66 mmol) of phosphoryl trichloride was diluted in 230 mL of dichloromethane in a round-bottom flask and then cooled in an ice bath. Then, a solution prepared by diluting 21.8 g (215.23 mmol) of triethylamine and 46.31 g (199.57 mmol) of 2,2,3,3,4,4,5,5-octafluoro-1-pentanol in 20 mL of dichloromethane was slowly added dropwise thereto for 1 hour, followed by stirring at room temperature for 3 hours. 30 g (195.66 mmol) of phosphoryl trichloride was diluted in 230 mL of dichloromethane in another round-bottom flask and then cooled in an ice bath. Then, a solution prepared by diluting 23.17 g (199.57 mmol) of 2-hydroxyethyl acrylate and 21.78 g (215.23 mmol) of triethylamine in 20 mL of dichloromethane was slowly added dropwise thereto for 1 hour, followed by stirring the resulting reaction mixture at room temperature for 3 hours. After completion of the first reactions, the resulting reaction products were filtered to remove the resulting amine salts, followed by collecting the two resulting filtrates into a single four-neck round-bottom flask. A solution prepared by dissolving 12.14 g (195.65 mmol) of ethylene glycol and 43.56 g (430.46 mmol) of triethylamine in 45 mL of dichloromethane was slowly added dropwise to the flask for 30 minutes, followed by stirring the reaction product at 40°C for 2 hours, and then the internal temperature of the flask was reduced to room temperature. After completion of the second reaction, a solution prepared by diluting 15.84 g (156.53 mmol) of triethylamine and 27.24 g (117.4 mmol) of 2,2,3,3,4,4,5,5-octafluoro-1-pentanol in 45 mL of dichloromethane was added to the flask. Thereafter, the resulting reaction mixture was stirred at room temperature for 15 hours and then filtered to remove the resulting amine salt. The resulting filtrate was concentrated under reduced pressure, subjected to extraction with ethyl acetate, and washed sequentially with a 1M aqueous hydrochloric acid solution, an aqueous sodium bicarbonate solution, and distilled water (once each). Thereafter, the resulting organic layer was dried over magnesium sulfate and filtered, followed by concentrating the resulting filtrate under reduced pressure, thereby obtaining 82 g of a liquid compound represented by Formula 1-12 (m:n = 1:3). The obtained compound had a refractive index of 1.361, as measured with an Abbe refractometer, and a viscosity of 586 cP, as measured with a rheometer.

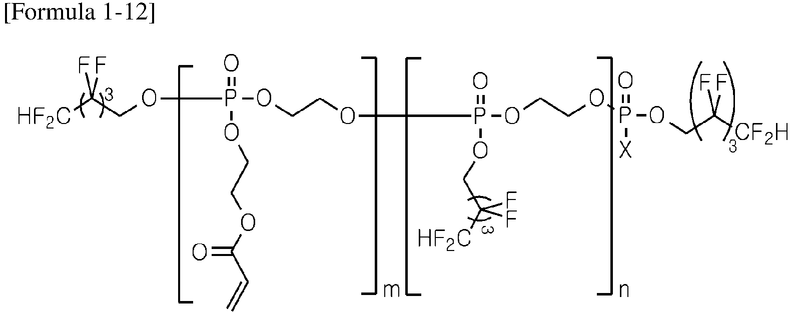

### Example 13

30 g (195.66 mmol) of phosphoryl trichloride was diluted in 230 mL of dichloromethane in a round-bottom flask and then cooled in an ice bath. Then, a solution prepared by diluting 30.4 g (300.12 mmol) of triethylamine and 69.46 g (299.35 mmol) of 2,2,3,3,4,4,5,5-octafluoro-1-pentanol in 20 mL of dichloromethane was slowly added dropwise thereto for 1 hour, followed by stirring at room temperature for 3 hours. 30 g (195.66 mmol) of phosphoryl trichloride was diluted in 230 mL of dichloromethane in another round-bottom flask and then cooled in an ice bath. Then, a solution prepared by diluting 11.58 g (99.78 mmol) of 2-hydroxyethyl acrylate and 15.18 g (100.23 mmol) of triethylamine in 20 mL of dichloromethane was slowly added dropwise thereto for 1 hour, followed by stirring the resulting reaction mixture at room temperature for 3 hours. After completion of the first reactions, the resulting reaction products were filtered to remove the resulting amine salts, followed by collecting the two resulting filtrates in a single four-neck round-bottom flask. A solution prepared by dissolving 11.76 g (195.65 mmol) of ethylenediamine and 43.56 g (430.46 mmol) of triethylamine in 45 mL of dichloromethane was slowly added dropwise to the flask for 30 minutes, followed by stirring the resulting reaction product at 40°C for 2 hours, and then the internal temperature of the flask was reduced to room temperature. After completion of the second reaction, a solution prepared by diluting 15.84 g (156.53 mmol) of triethylamine and 27.24 g (117.4 mmol) of 2,2,3,3,4,4,5,5-octafluoro-1-pentanol in 45 mL of dichloromethane was added to the flask. Thereafter, the resulting reaction mixture was stirred at room temperature for 15 hours and then filtered to remove the resulting amine salt. The resulting filtrate was concentrated under reduced pressure, subjected to extraction with ethyl acetate, and washed sequentially with a 1M aqueous hydrochloric acid solution, an aqueous sodium bicarbonate solution, and distilled water (once each). Thereafter, the resulting organic layer was dried over magnesium sulfate and filtered, followed by concentrating the filtrate under reduced pressure, thereby obtaining 95 g of a liquid compound represented by Formula 1-13. The obtained compound had a refractive index of 1.385, as measured with an Abbe refractometer, and a viscosity of 104,808 cP, as measured with a rheometer.

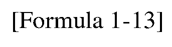

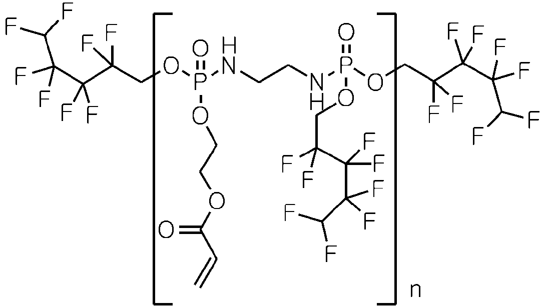

### Example 14

30 g (195.66 mmol) of phosphoryl trichloride was diluted in 230 mL of dichloromethane in a round-bottom flask and then cooled in an ice bath. Then, a solution prepared by diluting 21.8 g (215.23 mmol) of triethylamine and 46.31 g (199.57 mmol) of 2,2,3,3,4,4,5,5-octafluoro-1-pentanol in 20 mL of dichloromethane was slowly added dropwise thereto for 1 hour, followed by stirring at room temperature for 3 hours. 30 g (195.66 mmol) of phosphoryl trichloride was diluted in 230 mL of dichloromethane in another round-bottom flask and then cooled in an ice bath. Then, a solution prepared by diluting 23.17 g (199.57 mmol) of 2-hydroxyethyl acrylate and 21.78 g (215.23 mmol) of triethylamine in 20 mL of dichloromethane was slowly added dropwise thereto for 1 hour, followed by stirring the resulting reaction mixture at room temperature for 3 hours. After completion of the first reactions, the resulting reaction products were filtered to remove the resulting amine salts, followed by collecting the two resulting filtrates in a single four-neck round-bottom flask. A solution prepared by dissolving 23.12 g (195.66 mmol) of 1,6-hexanediol and 41.58 g (418.89 mmol) of triethylamine in 45 mL of dichloromethane was slowly added dropwise to the flask for 30 minutes, followed by stirring the resulting reaction product at 40°C for 2 hours, and then the internal temperature of the flask was reduced to room temperature. After completion of the second reaction, a solution prepared by diluting 15.84 g (156.53 mmol) of triethylamine and 27.24 g (117.4 mmol) of 2,2,3,3,4,4,5,5-octafluoro-1-pentanol in 45 mL of dichloromethane was added to the flask. Thereafter, the resulting reaction mixture was stirred at room temperature for 15 hours and then filtered to remove the resulting amine salt. The resulting filtrate was concentrated under reduced pressure, subjected to extraction with ethyl acetate, and washed sequentially with a 1M aqueous hydrochloric acid solution, an aqueous sodium bicarbonate solution, and distilled water (once each). Thereafter, the resulting organic layer was dried over magnesium sulfate and filtered, followed by concentrating the filtrate under reduced pressure, thereby obtaining 105 g of a liquid compound represented by Formula 1-14. The obtained compound had a refractive index of 1.399, as measured with an Abbe refractometer, and a viscosity of 1,923 cP, as measured with a rheometer.

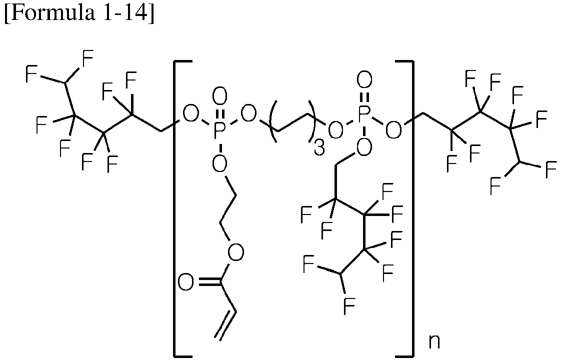

### Comparative Examples 1 and 2

A compound represented by Formula 7 (V-3F, Shin-Nakamura Chemical Co., Ltd.) and a compound represented by Formula 8 (DA-FO, Shin-Nakamura Chemical Co., Ltd.) were used as Comparative Examples 1 and 2, respectively.

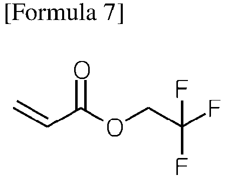

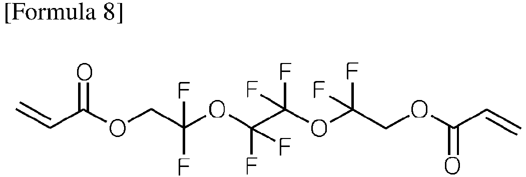

### <Experimental Example>

### 1. Measurement of refractive index

The refractive index of each of the compounds according to Examples and Comparative Examples was measured using an Abbe refractometer (NAR 1T, ATAGO Co., Ltd.) and results are shown in Table 1.

### 2. Measurement of viscosity

The viscosity of each of the compounds according to Examples and Comparative Examples was measured using a rheometer (MCR 702 TwinDrive, Anton Paar GmbH) and results are shown in Table 1.

**Table 1**

| | Refractive index | Viscosity (cP) |
|---|---|---|
| Example 1 | 1.379 | 103 |
| Example 2 | 1.392 | 372 |
| Example 3 | 1.386 | 8263 |
| Example 4 | 1.366 | 495 |
| Example 5 | 1.368 | 70 |
| Example 6 | 1.394 | 206 |
| Example 7 | 1.371 | 2452 |
| Example 8 | 1.393 | 52146 |
| Example 9 | 1.377 | 124 |
| Example 10 | 1.403 | 3284 |
| Example 11 | 1.369 | 153 |
| Example 12 | 1.361 | 586 |
| Example 13 | 1.385 | 104808 |
| Example 14 | 1.399 | 1923 |
| Comparative Example 1 | 1.348 | 1.1 |
| Comparative Example 2 | 1.380 | 10 |

Referring to Table 1, it was confirmed that the low refractive index compounds prepared in Examples 1 to 14 according to the present invention, all of which fall within the scope of Formula 1 according to the present invention, achieved both low refractive index properties (refractive index of 1.41 or less) and high viscosity properties (viscosity of 70 cP or more). Accordingly, it can be seen that optical films formed using the low refractive index compound according to the present invention will exhibit enhanced mechanical strength and scratch resistance and will be suitable for use in mold patterning capable of precise microstructure formation, thereby enabling economical production of high-quality, low refractive index optical films with uniform quality.

Conversely, it was confirmed that the low refractive index compounds according to Comparative Examples 1 and 2, which do not contain a phosphine compound in the backbone thereof, had a viscosity of 10 cP or less and thus failed to achieve high viscosity properties, despite exhibiting a low refractive index of 1.41 or less. Accordingly, it can be seen that optical films formed using such a compound will suffer from insufficient mechanical strength and poor scratch resistance, making the optical films unsuitable for use in mold patterning.

### 3. Measurement of molecular weight

The number average molecular weight (Mn), weight average molecular weight (Mw), and polydispersity index (PDI) of each of the low refractive index compounds synthesized in Examples were measured by GPC analysis (Waters 2414 refractive index detector/1515 isocratic HPLC pump) and results are shown in Table 2.

**Table 2**

| | Number average molecular weight (Mn) | Weight average molecular weight (Mw) | Polydispersity index (PDI=Mw/Mn) |
|---|---|---|---|
| Example 3 | 1232 | 4523 | 2.32 |
| Example 4 | 752 | 2142 | 2.03 |
| Example 8 | 1124 | 3865 | 1.86 |
| Example 9 | 685 | 1865 | 2.23 |
| Example 10 | 986 | 3568 | 1.96 |
| Example 11 | 569 | 2353 | 2.18 |
| Example 12 | 459 | 1932 | 1.99 |
| Example 13 | 1365 | 5622 | 2.33 |
| Example 14 | 1211 | 3966 | 2.31 |

## Claims

1. A low refractive index compound represented by Formula 1: 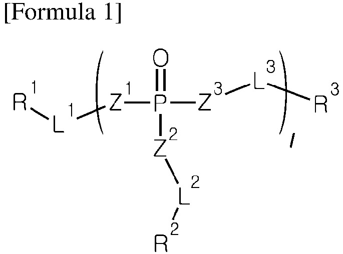
where Z¹ to Z³ are each independently -NH- or -O-,
L¹ to L³ are each independently a C₁ to C₁₂ hydrocarbon group, provided that a hydrogen atom contained in the hydrocarbon group may be substituted with fluorine, a C₁ to C₁₀ alkyl group, or a C₁ to C₁₀ alkanol group,
R¹ to R³ are each independently a reactive group or a fluorine (F)-containing group, provided that there is no case in which all of R¹ to R³ are reactive groups or all of R¹ to R³ are fluorine-containing groups,
l is an integer of 1 to 100, provided that, when l is an integer of 2 to 100, a plurality of 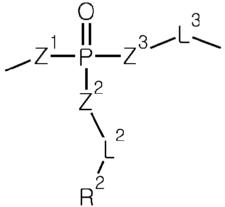 are identical to each other or different from each other,
the reactive group is an acryl group or a methacryl group, and
the fluorine-containing group is -(CF₂)ₓ-CHF₂ or -(CF₂)_{y}-CH₂OH (x and y being each independently an integer of 1 to 10).

2. The low refractive index compound according to claim 1, wherein the compound represented by Formula 1 is a compound represented by Formula 2: 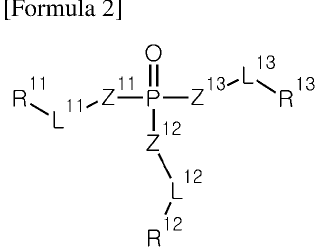
where Z¹¹ to Z¹³ are each independently -NH- or -O-,
L¹¹ to L¹³ are each independently a C₁ to C₁₂ hydrocarbon group, provided that a hydrogen atom contained in the hydrocarbon group may be substituted with fluorine, a C₁ to C₁₀ alkyl group, or a C₁ to C₁₀ alkanol group,
R¹¹ to R¹³ are each independently a reactive group or a fluorine-containing group, provided that there is no case in which all of R¹¹ to R¹³ are reactive groups or all of R¹¹ to R¹³ are fluorine-containing groups,
the reactive group is an acryl group or a methacryl group, and
the fluorine-containing group is -(CF₂)ₓ-CHF₂ or -(CF₂)_{y}-CH₂OH (x and y being each independently an integer of 1 to 10).

3. The low refractive index compound according to claim 1, wherein the compound represented by Formula 1 is a copolymer represented by Formula 3: 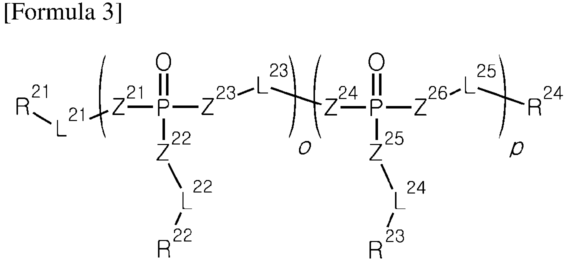
where Z²¹ to Z²⁶ are each independently -NH- or -O-,
L²¹ to L²⁵ are each independently a C₁ to C₁₂ hydrocarbon group, provided that a hydrogen atom contained in the hydrocarbon group may be substituted with fluorine, a C₁ to C₁₀ alkyl group, or a C₁ to C₁₀ alkanol group,
R²¹ to R²⁴ are each independently a reactive group or a fluorine-containing group, provided that there is no case in which all of R²¹ to R²⁴ are reactive groups or all of R²¹ to R²⁴ are fluorine-containing groups,
o and p are each independently an integer of 1 to 20,
the reactive group is an acryl group or a methacryl group, and
the fluorine-containing group is -(CF₂)ₓ-CHF₂ or -(CF₂)_{y}-CH₂OH (x and y being each independently an integer of 1 to 10).

4. The low refractive index compound according to claim 1, wherein the compound represented by Formula 1 is a copolymer represented by Formula 4: 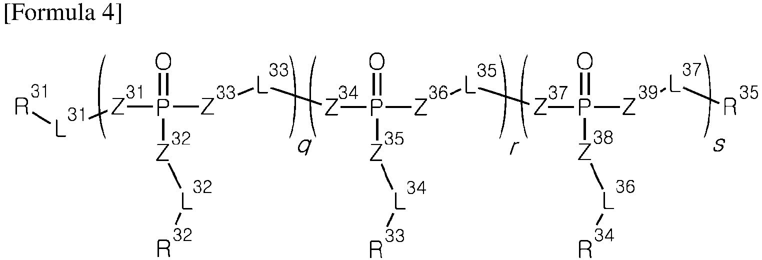
where Z³¹ to Z³⁹ are each independently -NH- or -O-,
L³¹ to L³⁷ are each independently a C₁ to C₁₂ hydrocarbon group, provided that a hydrogen atom contained in the hydrocarbon group may be substituted with fluorine, a C₁ to C₁₀ alkyl group, or a C₁ to C₁₀ alkanol group,
R³¹ to R³⁵ are each independently a reactive group or a fluorine-containing group, provided that there is no case in which all of R³¹ to R³⁵ are reactive groups or all of R³¹ to R³⁵ are fluorine-containing groups,
q, r, and s are each independently an integer of 1 to 20,
the reactive group is an acryl group or a methacryl group, and
the fluorine-containing group is -(CF₂)ₓ-CHF₂ or -(CF₂)_{y}-CH₂OH (x and y being each independently an integer of 1 to 10).

5. The low refractive index compound according to claim 1, wherein the low refractive index compound has a refractive index of 1.34 to 1.41.

6. The low refractive index compound according to claim 1, wherein the low refractive index compound has a viscosity of 50 cP or more.

7. A method of preparing a low refractive index compound, comprising:
(a) synthesizing a low refractive index compound using a phosphoryl halide, a compound containing a reactive group, and a compound containing a fluorine-containing group; and
(b) purifying the synthesized low refractive index compound,
wherein the compound having a reactive group is a compound represented by Formula 5, and
the compound having a fluorine-containing group is HO-(CF₂)ₓ-CHF₂ or HOCH₂-(CF₂)_{y}-CH₂OH (x and y being each independently an integer of 1 to 10). 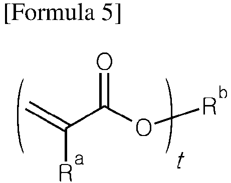
where R^{a} is a hydrogen atom or a methyl group,
R^{b} is a C₁ to C₁₂ hydrocarbon group having a terminal -OH group, and
t is an integer of 1 to 3.

8. The method according to claim 7, wherein step (a) comprises synthesizing the low refractive index compound further using a compound represented by Formula 6: 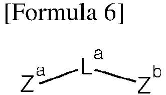
where Z^{a} and Z^{b} are each independently -NH₂ or -OH, and
L^{a} is a C₁ to C₁₂ hydrocarbon group, provided that a hydrogen atom contained in the hydrocarbon group may be substituted with fluorine, a C₁ to C₁₀ alkyl group, or a C₁ to C₁₀ alkanol group.

9. The method according to claim 7, wherein the low refractive index compound is a compound represented by Formula 1: 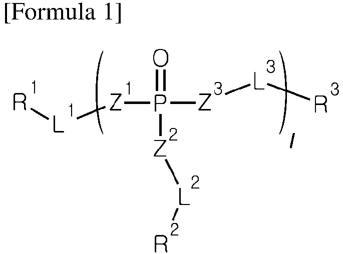
where Z¹ to Z³ are each independently -NH- or -O-,
L¹ to L³ are each independently a C₁ to C₁₂ hydrocarbon group, provided that a hydrogen atom contained in the hydrocarbon group may be substituted with fluorine, a C₁ to C₁₀ alkyl group, or a C₁ to C₁₀ alkanol group,
R¹ to R³ are each independently a reactive group or a fluorine-containing group, provided that there is no case in which all of R¹ to R³ are reactive groups or all of R¹ to R³ are fluorine-containing groups,
l is an integer of 1 to 100, provided that, when l is an integer of 2 to 100, a plurality of 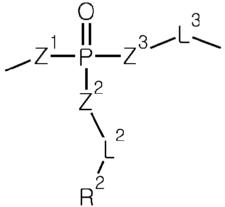 are identical to each other or different from each other,
the reactive group is an acryl group or a methacryl group, and
the fluorine-containing group is -(CF₂)ₓ-CHF₂ or -(CF₂)_{y}-CH₂OH (x and y being each independently an integer of 1 to 10).

10. A low refractive index optical film comprising the low refractive index compound according to any one of claims 1 to 6.

11. A display apparatus comprising the low refractive index optical film according to claim 10.
